# EUROPEAN PATENT APPLICATION

(11) **EP 1 462 963 A1**
(43) Date of publication of application: **29.09.2004**
(21) Application number: 03388019.6
(22) Date of filing: 26.03.2003
(51) Int. Cl.: G06F 17/50

(54) **Computer-implemented method of selecting a profiled element for a load-bearing structure**

(71) Applicant: FIBERLINE A/S, DK-6000 Kolding (DK)
(72) Inventor: Thorning, Henrik, DK-6000 Kolding (DK)
(74) Representative: Nielsen, Henrik Sten

(57) **Abstract**

A method of selecting and delivering a profiled, composite pulltruded element for a load-bearing structure comprises: Providing load requirements and dimensions of the load-bearing structure, addressing a homepage and selecting from a list of profiled, composite pulltruded elements included in a database a specific profiled, composite pulltruded element and defining specific dimensions thereof corresponding to the dimensions of the load-bearing structure, and addressing a calculation program from the homepage for calculating the specific load capability of the specific profiled, composite pulltruded element for comparing the specific load capability with the load requirements of the structure for determining whether or not the load requirements be fulfilled or not. A positive validation response is forwarded from the calculation program via the homepage provided the comparison establishes the fulfilment of the load requirements or in the alternative, provided the comparison establishes the non-fulfilment of the load requirements, a negative validation response is forwarded and the calculation program selects an alternative profiled, composite pulltruded element from the list, and calculates the load capability thereof for comparison with the load requirements for selecting an alternative profiled, composite pulltruded element from the list fulfilling the load requirements and forwards data identifying the alternative profiled, composite pulltruded element along with the negative validation response to the computer. The method further comprises output of the positive validation response or in the alternative the negative validation response together with the data from the computer, returning an order to the homepage for the delivery of the specific profiled, composite pulltruded element or in the alternative the alternative profiled, composite pulltruded element, and delivery of the specific profiled, composite pulltruded element or in the alternative the alternative profiled, composite pulltruded element from a factory.

## Description

The present invention relates to a novel technique of designing and constructing load-bearing structures such as bridges, houses, etc. More specifically, the present invention relates to a novel method of selecting and delivering a profiled, composite pulltruded element for a load-bearing structure.

Within the last decade, the use of composite pulltruded elements, in particular profiled elements, has increased significantly and the industry has realised that the light-weight high-strength and corrosion resistant elements produced through composite pulltrusion constitute structural elements which do not only allow the conventional concrete steel and wooden structural elements to be substituted, rather allows the construction of high-strength and light-weight structures having highly advantageous properties as compared to similar conventional structures made from concrete and steel.

The applicant company has delivered load-bearing structures for a number of applications within the last decade among which applications the following may be mentioned: foot- or bicyclebridge, ferry pier, connecting bridge for offshore drilling rigs, landing stages, footbridges in industrial plants, cooling towers, gratings, ladders and railing systems, facings for buildings, etc. The applicant company being one of the major European suppliers of profiled, composite pulltruded elements has delivered a construction manual for the company's customers which construction manual includes description of the various profile elements, fittings, etc. which are delivered by the applicant company.

The conventional designing and construction of a load-bearing structure such as a bridge or any of the above described structural elements or other structural element built from profiled, composite pulltruded elements involves the provision of measures of the structure to be manufactured, dimensioning and designing the load-bearing structure from profiled, composite pulltruded elements e.g. by the use of the construction manual and checking of the load-bearing capability of the final load-bearing structure, the request of delivery or ordering of the profiled, composite pulltruded elements by a pulltrusion factory and finally the delivery of the profiled, composite pulltruded elements. This technique of dimensioning, designing and building a load-bearing structure from profiled, composite pulltruded elements involves a number of individual or separate steps, some of which may be performed by the use of a computer including the mailing of orders on the internet, however fails to include a reliable and safe checking of the capabilities of the load-bearing structure preventing that the final load-bearing structure be incorrectly dimensioned and designed an example of incorrect designing and dimensioning being the recently collapsed bicycle arena in Copenhagen named the Siemens arena in Ballerup close to the city of Copenhagen.

It is an object of the present invention to provide a novel technique of selecting and delivering profiled, composite pulltruded elements for a load-bearing structure involving a safe dimensioning and designing routine eliminating to a reasonable extent the risk of having an incorrectly designed load-bearing structure.

It is an advantage of the present invention that the novel method of selecting and delivering profiled, composite pulltruded elements for a load-bearing structure allows the overall method to be performed by means of a computer allowing an online dimensioning and designing, ordering and delivery confirmation to be obtained also eliminating any faulty delivery of incorrectly designed elements for the load-bearing structure.

A particular feature of the present invention relates to the fact that the novel method of selecting and delivering a profiled, composite pulltruded element for a load-bearing structure allows the technician to dimension and design the load-bearing structure in question from profiled, composite pulltruded elements by the use of the technician's own computer in an online set-up in which the latest high-strength elements be presented to the technician and in which online set-up the verification of the load-bearing capability of the load-bearing structure in question be insured by the continuous updating of the calculation program presented to the technician in the online set-up.

A further advantage obtained by the novel method of selecting and delivering a profiled, composite pulltruded element for a load-bearing structure as compared to the manual designing and dimensioning of the load-bearing structure relates to an inherent optimisation routine performed in the designing step carried out in the online set-up.

The above object, the above advantages and the above feature together with numerous other objects, advantages and features which will be evident from the below detailed description of the present invention are according to the teachings of the present invention obtained by means of a method of selecting and delivering a profiled, composite pulltruded element for a load-bearing structure, said method comprising:
i) providing load requirements and dimensions of the load-bearing structure,
ii) providing a computer having an internet connection, an input means and an output means, and a server including a homepage and having an internet connection, the server further including a database including a list of profiled, composite pulltruded elements and a calculation program for calculating the load capability of any of the profiled, composite pulltruded elements of the list and having any specific dimensions, and the homepage having links to the database and to the calculation program,
iii) addressing the homepage and selecting from the list of profiled, composite pulltruded elements included in the database a specific profited, composite pulltruded element and defining specific dimensions thereof corresponding to the dimensions of the load-bearing structure,
iv) addressing the calculation program from the homepage for calculating the specific load capability of the specific profiled, composite pulltruded element of the specific dimensions and performing a comparison for comparing the specific load capability with the load requirements of the structure for determining whether or not the load requirements be fulfilled or not,
v) forwarding a positive validation response from the calculation program via the homepage provided the comparison in step iv) establishes the fulfilment of the load requirements or in the alternative, provided the comparison in step iv) establishes the non-fulfilment of the load requirements, forwarding a negative validation response and the calculation program selecting an alternative profiled, composite pulltruded element from the list and having the specific dimensions, and calculating the load capability thereof for comparison with the load requirements for selecting an alternative profiled, composite pulltruded element from the list fulfilling the load requirements and having the dimensions and forwarding data identifying the alternative profiled, composite pulltruded element along with the negative validation response to the computer,
vi) output of the positive validation response or in the alternative the negative validation response together with the data from the computer,
vii) returning an order to the homepage for the delivery of the specific profiled, composite pulltruded element or in the alternative the alternative profiled, composite pulltruded element, and
viii) delivery of the specific profiled, composite pulltruded element or in the alternative the alternative profiled, composite pulltruded element from a factory.

According to the basic teachings of the present invention, the technician is allowed to perform designing, dimensioning, selection and ordering of the relevant component being a profiled, composite pulltruded element for a load-bearing structure integrally involving a verification by the calculation program of the correctness of the load-bearing capability of the profiled, composite pulltruded element selected for the load-bearing structure. In more details, the novel technique according to the present invention involves the use of an online internet based set-up in which the technician based on the load requirements and the dimensions of the load-bearing structure to be designed and be manufactures from the profiled, composite pulltruded element or elements addresses homepage from which access is obtained to a database including an updated list of profiled, composite pulltruded elements available for the technicians and also having a link to a calculation program which is also currently updated based on imperical and theoretical analysis and results allowing the technician to choose a specific profiled, composite pulltruded element from the list fulfilling certain dimensional and design criteria and based on the load requirements and the dimensions of the load-bearing structure asks the calculation program to determine whether or not the load-bearing capability of the specific profiled, composite pulltruded element chosen fulfils the load-bearing requirements of the structure.

The calculation program determines whether or not the load-bearing requirements be fulfilled or not and informs via the internet from the homepage the technicians about the fulfilment or non-fulfilment of the load requirements. The validation response is a positive validation response or alternatively a negative validation response output to the computer operated by the technician. Provided the negative validation response be output, the homepage also informs the technicians, based on the calculation performed by the calculation program, about the existence of a possible alternative profiled, composite pulltruded element fulfilling the load-bearing requirements of the load-bearing structure. The technician then returns the order to the homepage for the delivery and from the homepage, the order is transmitted to the pulltrusion factory from which the selected profiled, composite pulltruded element being the specific profiled, composite pulltruded element or in the alternative the alternative profiled, composite pulltruded element is delivered.

The method according to the present invention is according to a further aspect of the present invention refined as the method may advantageously further comprise: the calculation program selecting, provided the comparison in step iv) establishes the non-fulfilment of the load requirements, in step iv) an alternative dimension of the specific profiled, composite pulltruded element and calculating the load capability thereof for comparison with the load requirements for selecting an alternative dimension of the profiled, composite pulltruded element fulfilling the load requirements and forwarding data identifying the alternative dimension of the profiled, composite pulltruded element along with the negative validation response to the computer for output of the validation response from the computer. According to this alternative embodiment of the method according to the present invention, the designing performed by the calculation program also involves a redefinition of the dimensions of the selected profiled, composite pulltruded element for complying with and fulfilling the load-bearing requirements of the load-bearing structure.

The method according to the present invention further allows, according to the basic teachings of the present invention of utilising the calculation program for defining various load conditions, various fixation and/or set-ups of the load-bearing structure in question and further allows the technician to determine the load-bearing capability of specific fittings to be used in combination with the profile, composite pulltruded elements included in the list of the database. Consequently, according to a presently preferred further embodiment of the method according to the present invention, the method comprising a plurality of sub steps including: Definition of static system, definition of combination of loads on said load-bearing structure,
definition of support of said load-bearing structure including definition of simple or elastic support, fixation or set-up or alternatively Charnier or hinged suspension.

The presently preferred embodiment of the method according to the present invention as defined above also includes the feature of allowing the technician to cooperate in the designing of the load-bearing structure the fittings or other elements such as the glue connections, bolt fixations etc. used in combination with the profile, composite pulltruded elements of the load-bearing structure. Consequently, according to a further embodiment according to the present invention, the database further including an additional list of fittings to be used in combination with the profile, composite pulltruded elements and the calculation program calculating the load capability of any of the fittings of the additional list in combination the specific profiled, composite pulltruded element determined in step iv) and v).

The determination and designing of the load-bearing structure preferably also includes, according to the basic teachings of the present invention: a supplementary list of glue connections or bolt connections and the calculation program calculating the load capability of the glue connection or bolt connection of any of the profiled composite pulltruded elements in combination with such connection and/or in combination with any of the fittings of said additional list.

The method according to the present invention preferably further is refined as the method advantageously comprises the database having the list of profiled, composite pulltruded elements organised in clusters of profiled, composite pulltruded elements having the same overall geometrical configuration, the clusters being further organised by ordering the clusters in increasing load capabilities of the profiled, composite pulltruded elements, or in the alternative decreasing load capabilities of the profiled, composite pulltruded elements.

As an alternative to the organisation of the profile, composite pulltruded elements in clusters of the list in the database, the homepage may alternatively include an organising program allowing the homepage itself to organise in the clusters the profiled, composite pulltruded elements from the list of profiled, composite pulltruded elements included in the database being an non-cluster organised database.

According to a particular optimisation feature of the method according to the present invention, the method according to the present invention preferably further comprises: the calculation program selecting, provided the comparison in step iv) establishes the non-fulfilment of the load requirements, an alternative specific profiled, composite pulltruded element from the cluster including the specific profiled, composite pulltruded element having a higher load capability.

Additionally or alternatively, the method further advantageously comprises: the calculation program selecting, provided the comparison in step iv) establishes the fulfilment of the load requirements, an alternative specific profiled, composite pulltruded element from the cluster including the specific profiled, composite pulltruded element having a lower load capability, the calculation program performing a calculation of an alternative specific load capability of the load-bearing structure comprising the alternative profiled, composite pulltruded element and performing a comparison for comparing the specific alternative load capability with the load requirements of the structure for determining whether or not the load requirements be fulfilled or not, and
the step v) including forwarding the positive validation response regarding the alternative profiled, composite pulltruded element from the calculation program via the homepage provided the comparison in step iv) establishes the fulfilment of the load requirements by the alternative profiled, composite pulltruded element or in the alternative, provided the comparison in step iv) establishes the non-fulfilment of the load requirements by the alternative profiled, composite pulltruded element forwarding no validation response from the calculation program via the homepage regarding the alternative profiled, composite pulltruded element.

Additionally or alternatively, the method further advantageously comprises: the forwarding in step v) further including the forwarding of information regarding the specific load capability determined in step iv) and the step further including output of the information along with the positive validation response or in the alternative the negative validation response.

The method according to the present invention may according to principles well known within the art per se such as the technique of presenting information on the internet and allowing access to different homepages, etc. be further refined for allowing the presentation of the relevant information including the validation response, the data and any additional information as discussed above to the technician for improving the utility of the online dimensioning designing and selection technique and also expediting the ordering and delivery of the selected profiled, composite pulltruded elements according to the method of the present invention.

According to the above discussed techniques of improving the ordering and delivery of the selected profiled, composite pulltruded element according to the teachings of the present invention, the method according to the present invention further preferably comprises in step vi) further including output of drawings of the load-bearing structure composed of said specific profiled, composite pulltruded element or in the alternative the alternative profiled, composite pulltruded element.

The online integration of the dimensioning, designing, ordering and delivering of a selected, profiled, composite pulltruded element for the manufacturing of a load-bearing structure may further be enhanced by communicating the specific profiled, composite pulltruded element or in the alternative the alternative profiled, composite pulltruded element from the homepage to an inventory program, the inventory program checking delivery times and stock of the specific profiled, composite pulltruded element or in the alternative the alternative profiled, composite pulltruded element and returning information regarding delivery times and stock to the homepage, thereby allowing the technician in the online set-up to ask the manufacturer or the factory producing profiled, composite pulltruded elements regarding delivery times and stock, prices, possible discounts, etc. as the method according to the present invention preferably further comprises: communicating the specific profiled, composite pulltruded element or in the alternative the alternative profiled, composite pulltruded element from the homepage to a bookkeeping program, the bookkeeping program checking the price of the specific profiled, composite pulltruded element or in the alternative the alternative profiled, composite pulltruded element and any discount options and returning information regarding the price and any discount options to the homepage.

The method of selecting and delivering a profiled, composite pulltruded element may further include the introductory and final steps of determining the dimensioning of the load-bearing structure and further determining the load requirements thereof and of building the load-bearing structure from the specific profiled, composite pulltruded element or in the alternative the alternative profiled, composite pulltruded element, respectively.

The step of determining the dimensions of the load-bearing structure and the step of determining the load requirements of the load-bearing structure may involve the physical work of measuring at the site at which the load-bearing structure is to be manufactured or alternatively determining the dimensions of the load-bearing structure from an existing technician's drawing and similarly, the determination of the load requirements may involve measurements or simple deduction from textbook or dimensioning or designing program of the relevant physical load to be impacted to the load-bearing structure.

The invention is now to be further described with reference to the drawings in which
Fig. 1 is a schematic and diagrammatic view of a computer implementation for carrying out the method according to the present invention,
Fig. 2 is a diagrammatic view of a flow of information in the computer implementation shown in Fig. 1,
Fig. 3 is a diagrammatic view of a scheme of establishing fulfilment of load-bearing capability of a profiled, composite pulltruded element of a load-bearing structure according to the teachings of the present invention, and
Fig. 4a-4g is screen printouts of a password-protected homepage including a prototype calculation program.

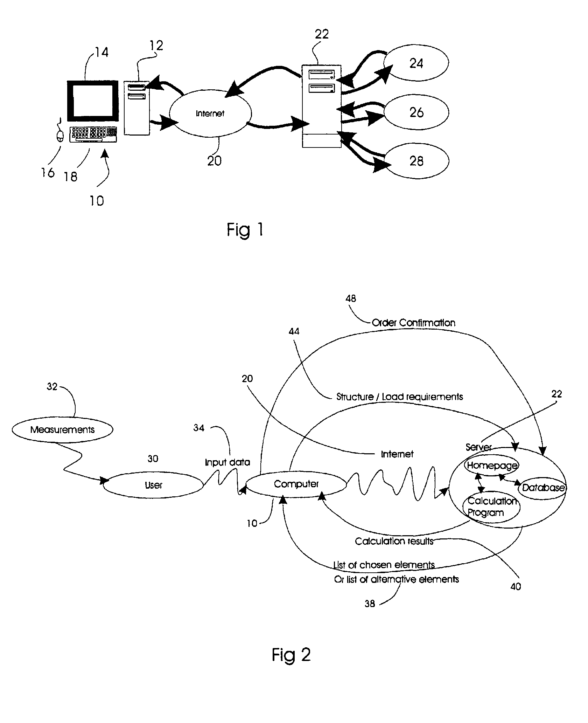

In Fig. 1, a computer set-up is illustrated including an Internet connection to a server further communicating with a homepage, a calculation program and a database.

in details, Fig. 1 illustrates a computer designated the reference numeral 10 in its entirety and including a CPU 12 connected to a screen 14 and a mouse 16 and a keyboard 18. The computer 10 is generally a conventional computer connected to the internet as is illustrated in Fig. 1 which internet is designated the reference numeral 20. The Internet 20 is also connected to a server 22 which further communicates with a homepage 24 to be described in greater details below, a calculation program 26 also to be described in greater details below and a list of profiled, composite pulltruded elements available for delivery from a pulltrusion factory or other supplier. The computer 10 is operated by a technician having the task of dimensioning and designing a load-bearing structure from one or more profiled, composite pulltruded elements to be delivered by the above-mentioned pulltrusion factory.

The computer 10 is connected directly to the internet connection 20, alternatively the computer is connected directly to the server via a modem, either analogue or digital (POTS/ISDN), further alternatively the computer is connected to an intranet (LAN) which has an Internet connection.

In Fig. 2, the flow of information is illustrated when a user 30, such as a technician, uses the method according to the present invention for the purpose of dimensioning and designing a load-bearing structure composed of profiled, composite pulltruded elements.

The user 30 uses the keyboard 18 and mouse 16 of the computer 10 for input of the dimensions of the structure, and the user further uses the homepage for selecting the geometry of the specific profiled, composite pulltruded elements from the database 28.

The calculation program 26 uses the information regarding the dimensions and selection of the specific profiled, composite pulltruded elements for calculating the specific load capability of the specific profiled, composite pulltruded element, or alternatively the load-bearing structure composed of the specific profiled, composite pulltruded elements designed by the technician.

The information regarding the profiled, composite pulltruded elements of the database 28 may be organised according to the overall geometrical configuration of the elements and also according to the load capabilities of the profiled, composite pulltruded elements, alternatively the calculation program 26 may include sorting routines for organising the information regarding the profiled, composite pulltruded elements.

The calculation program 26 performs a comparison of the load requirements specified by the technician to the specific load capabilities calculated from the load-bearing structure designed by the technician. Provided the comparison establishes the load requirements to be fulfilled the homepage 20 outputs a positive validation response and corresponding data of the load-bearing structure and data regarding the specific profiled, composite pulltruded elements. Provided the comparison establishes the load requirements to be non-fulfilled, the calculation program 26 chooses an alternative profiled, composite pulltruded element from the list, or the calculation program 26 chooses a profiled, composite pulltruded element having a load capability that is higher that that of the profiled, composite pulltruded element selected by the technician, alternativly the calculation program will choose another dimension of the profiled, composite pulltruded element and recalculate the specific load capability of the structure composed of the specific profiled, composite pulltruded elements having the alternative dimension.

Provided the calculation program 26 has determined that the load-bearing structure designed by the technician fulfils the load requirements, the homepage 24 returns an order confirmation 24 to the technician 30, the order confirmation 24 may include price information regarding the delivery of the structure composed of the profiled, composite pulltruded element.

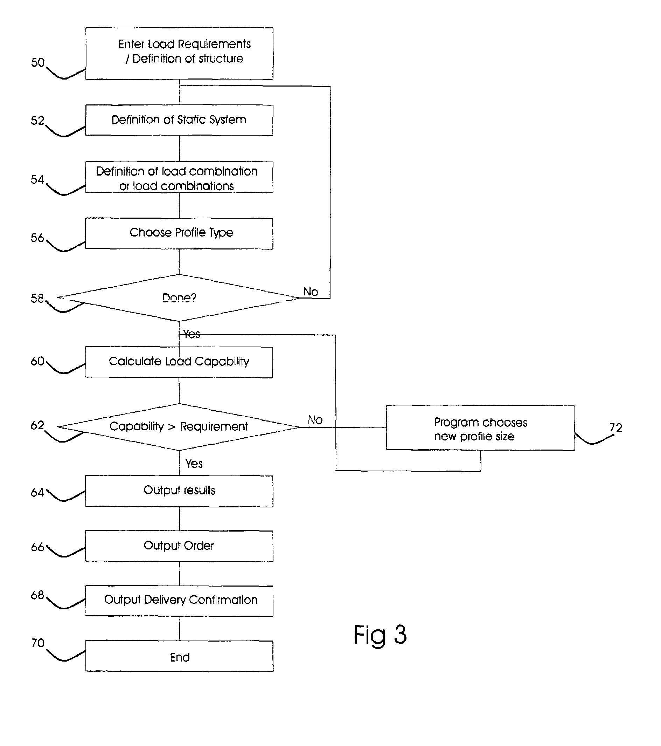

In Fig. 3, a flow chart of the operation of selecting and delivering a profiled, composite pulltruded element for a load-bearing structure is illustrated.

In block 50, the user, such as a technician, uses the mouse 16 and keyboard 18 of the computer 10 to access the homepage 24 in order to enter load requirements of a load-bearing structure composed of a profiled, composite pulltruded element or elements. In block 52 the user accesses the homepage 24 to define the static system. In block 54, the user defines the load combination or load combinations, and in block 56, the user selects a profiled, composite pulltruded element type from the database 28, and in block 56 enter the corresponding dimensions thereof to the homepage. The load-bearing structure may be composed of one or more profiled, composite pulltruded elements so the user has the option in step 58 to repeat step 52 to 56. When the user has completed the selection and dimensioning of the load-bearing structure the calculation program 26 calculates the load capability of the specific load-bearing structure in step 60. In step 62 a comparison is performed for the purpose of establishing whether or not the load requirements are fulfilled by the specific load capabilities of the specific load-bearing structure. Provided the fulfilment of the load requirements for the load-bearing structure is established by the specific load-bearing structure in step 62, the calculation program 26 continues to step 64 where the results of the calculation is forwarded to the homepage, subsequently the calculation program 26 forwards an order sheet to the homepage 24 in step 66. In step 68 a delivery confirmation is forwarded to the homepage 24 for the user to return to a factory producing profiled, composite pulltruded elements, or in the alternative to another delivery source of profiled, composite pulltruded elements. If, however, in step 62 the non-fulfilment of the load requirements of the load-bearing structure is established, the calculation program 26 chooses an alternative size of the geometry of the selected profiled, composite pulltruded element from the database 28, or in the alternative the calculation program 26 chooses another dimension of the selected profiled, composite pulltruded element, alternatively the calculation program 26 chooses another geometry of the profiled, composite pulltruded element, the program iterates the steps 60, 62 and 72 until the load requirements are fulfilled, thereafter the calculation program 26 continues with step 64 to 70 as described above, alternatively if the load requirements not be fulfilled using any of dimension of the profiled, composite pulltruded elements the calculation program 26 returns a warning to the user via the homepage 24.
After step 62 the calculation program 26 alternatively chooses an alternative profile size/strength having a lower load-bearing capability for checking that the user has chosen a too heavy and large load-bearing structural element, and thereby waste of money and resources may be avoided.

According to a particular feature of the technique according to the present invention, the step 52 of defining the static system and the step of defining the load combination or load combinations of the load-bearing structure may further involve the definition of a simple or a suspended support, a specific set-up or fixation or a Charnier or hinged set-up or fixation. According to a further embodiment of the method according to the present invention, the determination and selection of a specific profile, composite pulltruded element for a specific load-bearing structure may be modified by the determination and selection of specific fittings to be used in combination with the composite pulltruded element chosen or selected and also for determining the capability of specific connections or junctions such as junctions established by means of the fittings, glue connections, bolt connections etc. Consequently, according to this refined or alternative technique, the calculation program also includes a list of fittings and/or in addition, a list of specific connections or junctions, such as glue or bolt connections etc.

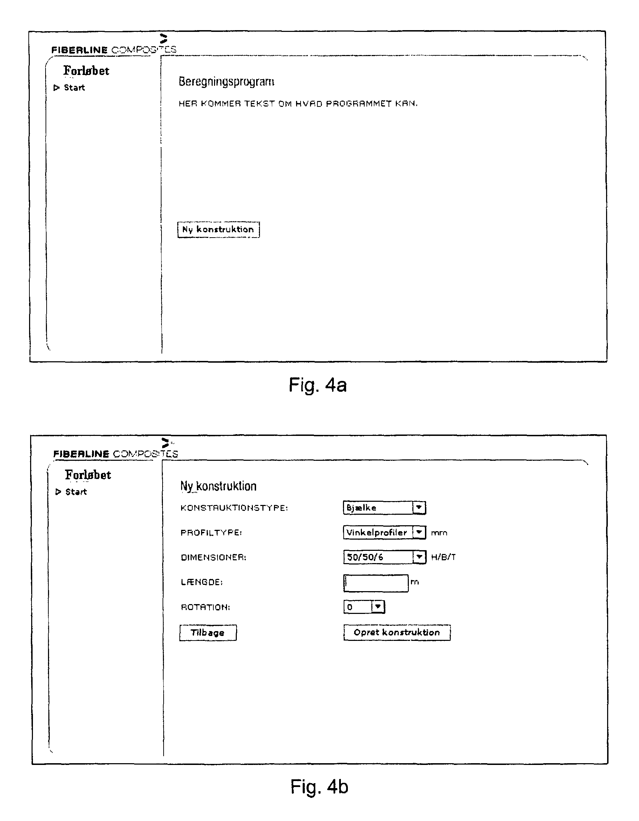

In Fig. 4a, a password-protected homepage including a prototype of a calculation program is illustrated.

In Fig. 4b, the password-protected homepage of fig. 4a including a selection of a profiled, composite pulltruded element and corresponding dimensions is illustrated.

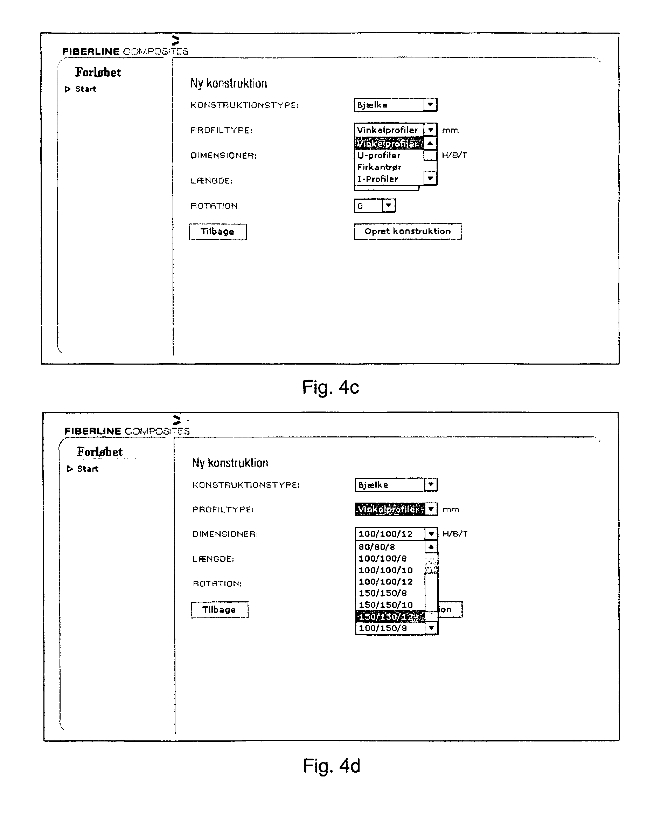

In Fig. 4c, the password-protected homepage of fig. 4a including a list comprising profiled, composite pulltruded elements having different overall geometrical configurations is illustrated.

ln Fig. 4d, the password-protected homepage of fig. 4a including a list comprising profiled, composite pulltruded elements having different cross-sectional dimensions is illustrated.

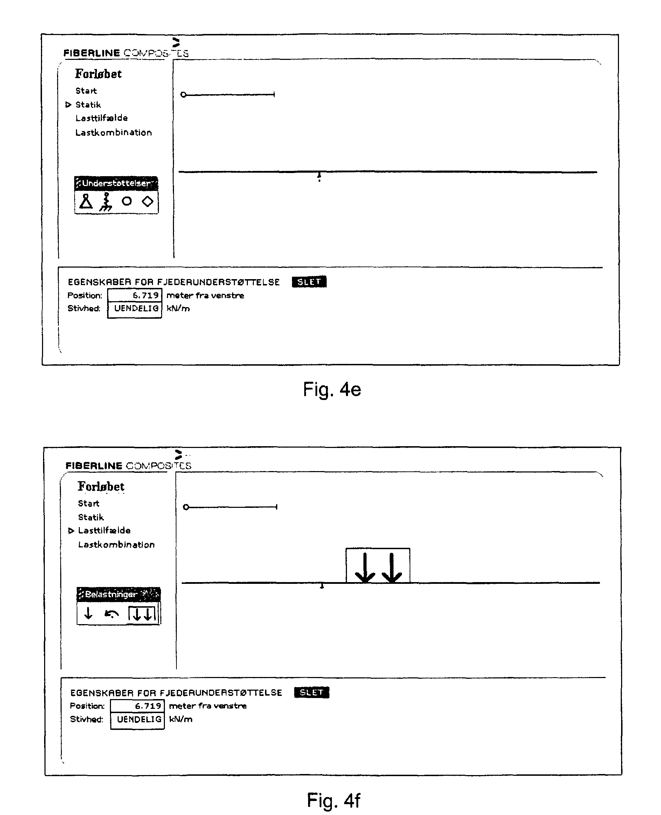

in Fig. 4e, the password-protected homepage of fig. 4a including a computer simulation of the support of the load-bearing structure.

In Fig. 4f, the password-protected homepage of fig. 4a including a computer simulation of the loads exerted on the load-bearing structure.

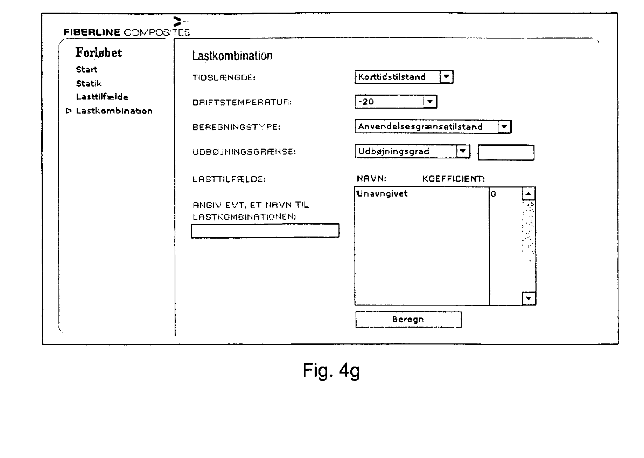

ln Fig. 4g, the password-protected homepage of fig. 4a including a computer simulation of a combination of loads exerted on the load-bearing structure.

The general principles of static calculation and dimensioning of load-bearing elements or structures are described in the annex 1, bearing the title "Baereberegning af kontinuert bjaelke med normal kraft udført af et bjaelkeprofil fra Fiberline"

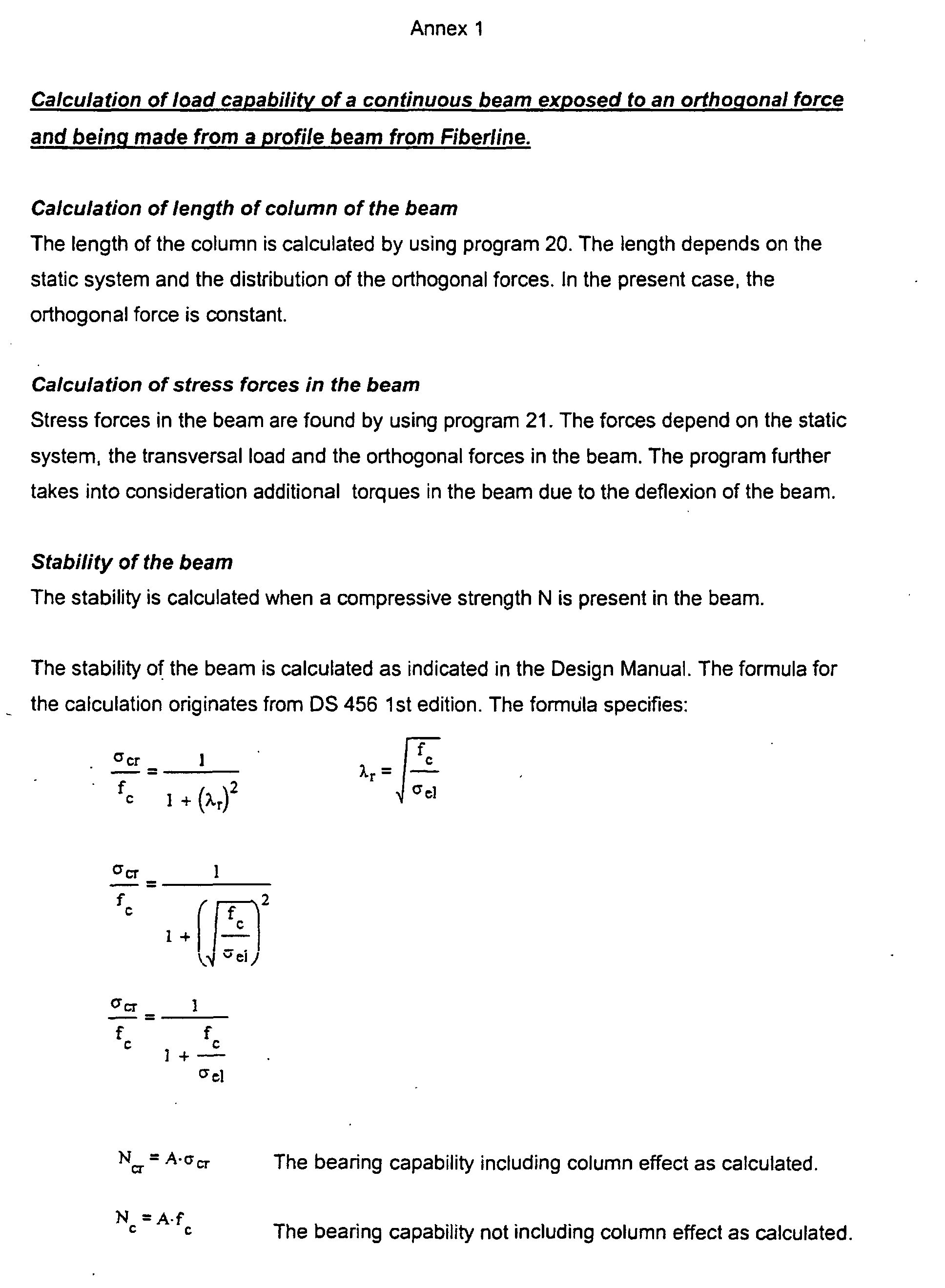

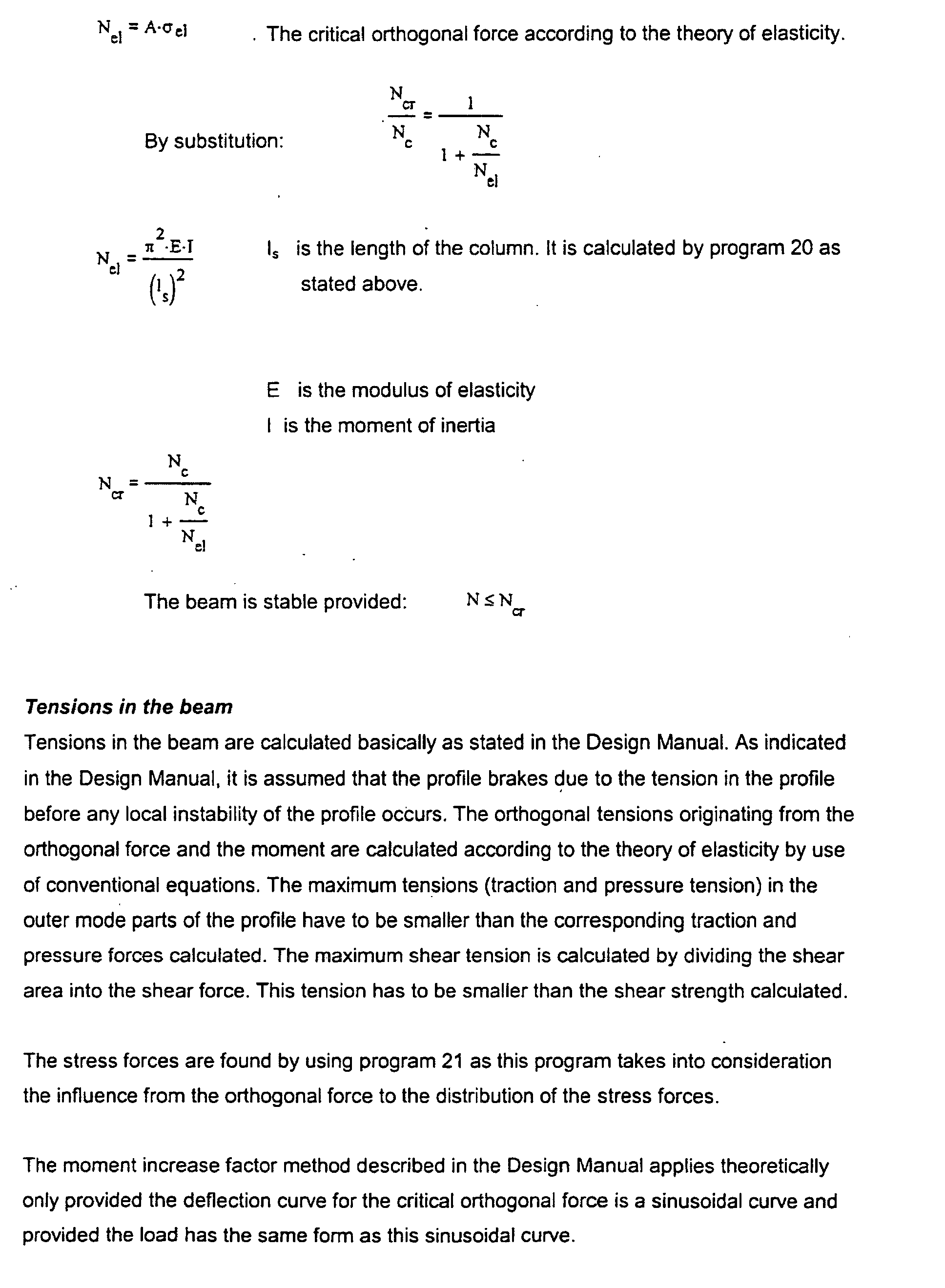

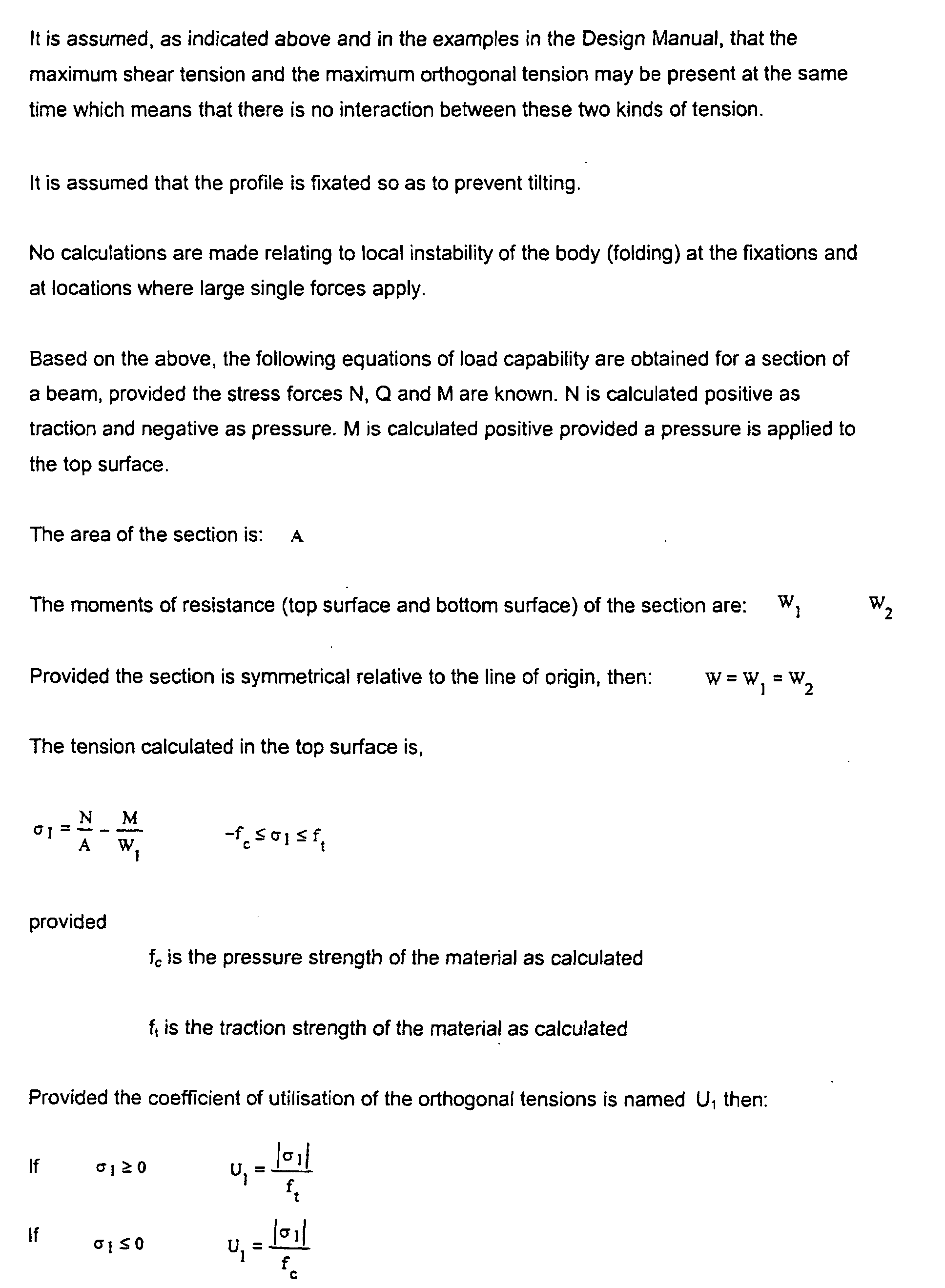

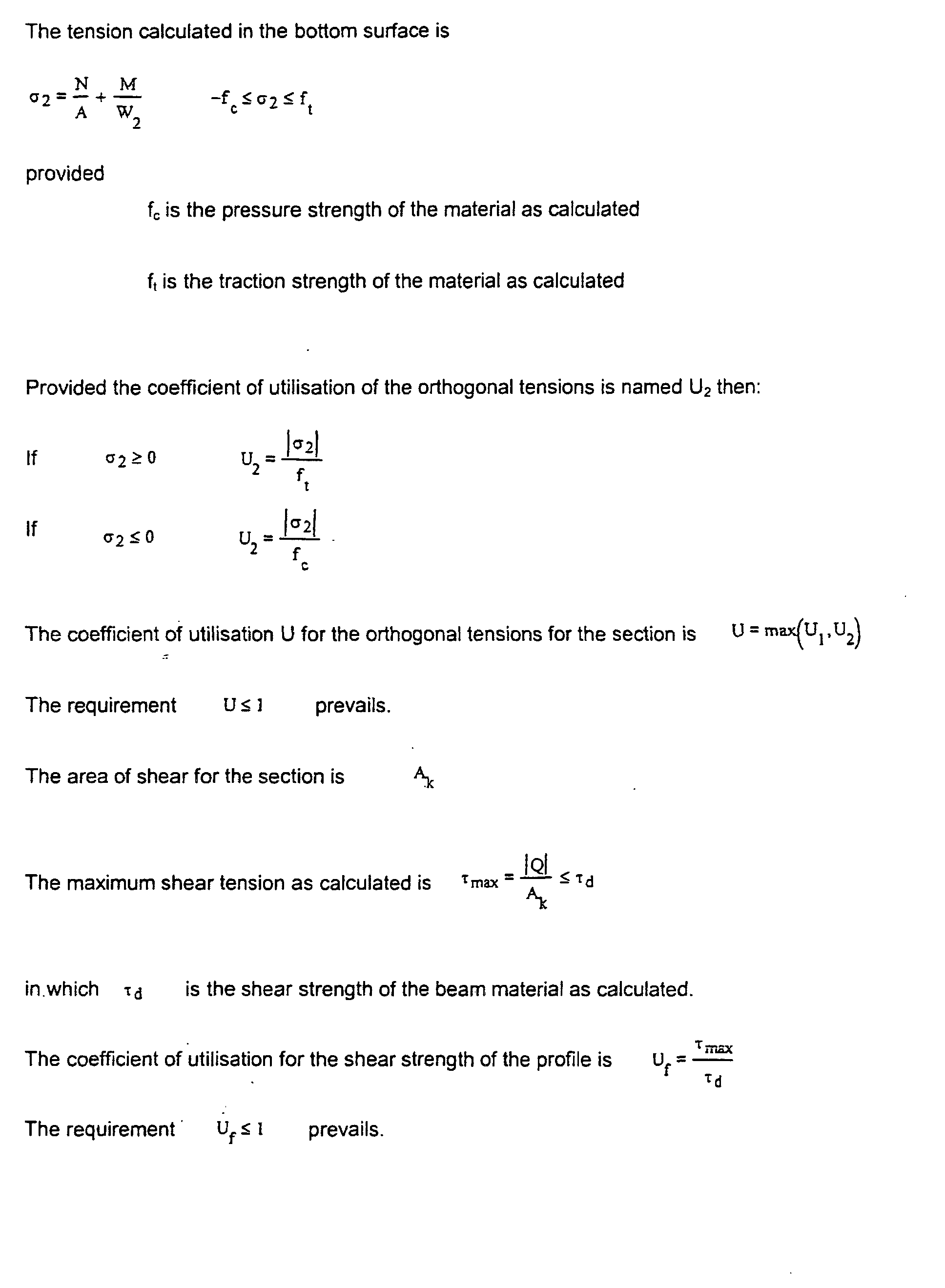

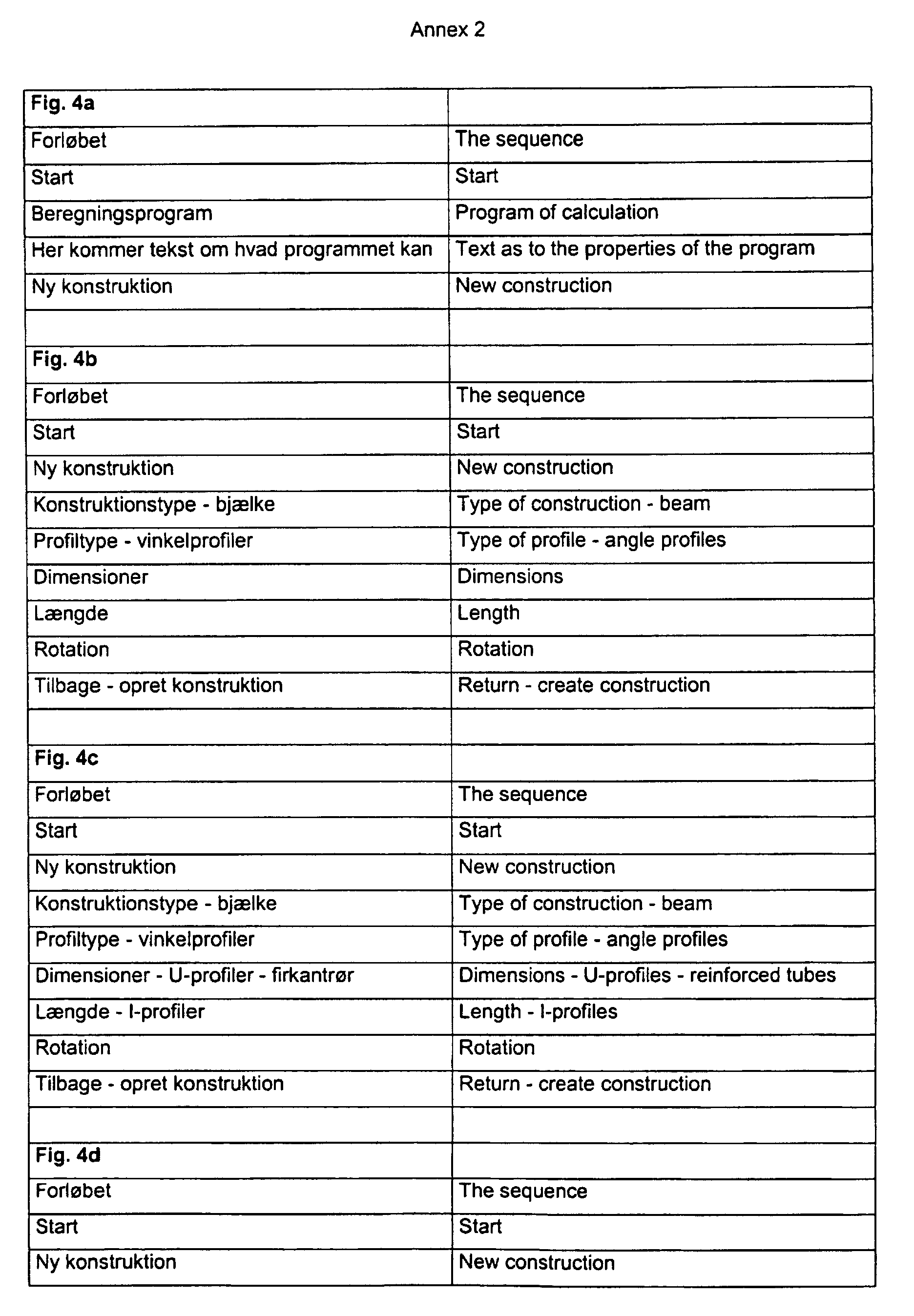

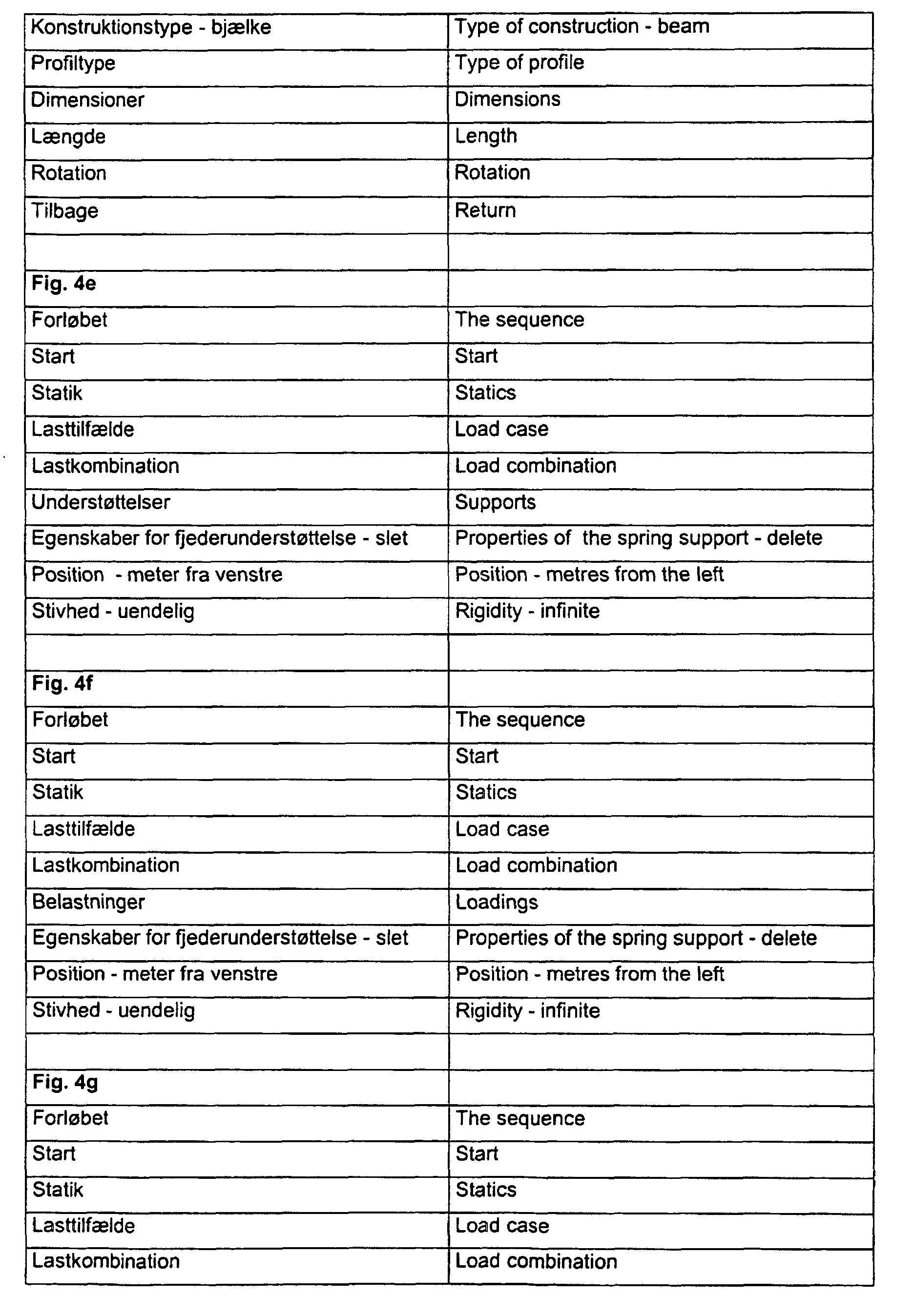

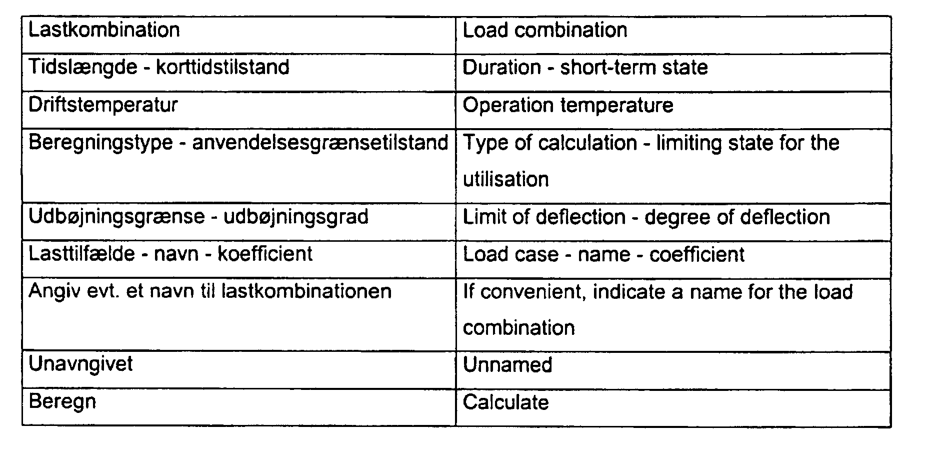

## Claims

1. A method of selecting and delivering a profiled, composite pulltruded element for a load-bearing structure, said method comprising:
i) providing load requirements and dimensions of said load-bearing structure,
ii) providing a computer having an internet connection, an input means and an output means, and a server including a homepage and having an internet connection, said server further including a database including a list of profiled, composite pulltruded elements and a calculation program for calculating the load capability of any of said profiled, composite pulltruded elements of said list and having any specific dimensions, and said homepage having links to said database and to said calculation program,
iii) addressing said homepage and selecting from said list of profiled, composite pulltruded elements included in said database a specific profiled, composite pulltruded element and defining specific dimensions thereof corresponding to said dimensions of said load-bearing structure,
iv) addressing said calculation program from said homepage for calculating the specific load capability of said specific profiled, composite pulltruded element of said specific dimensions and performing a comparison for comparing said specific load capability with said load requirements of said structure for determining whether or not said load requirements be fulfilled or not,
v) forwarding a positive validation response from said calculation program via said homepage provided said comparison in step iv) establishes the fulfilment of said load requirements or in the alternative, provided said comparison in step iv) establishes the non-fulfilment of said load requirements, forwarding a negative validation response and said calculation program selecting an alternative profiled, composite pulltruded element from said list and having said specific dimensions, and calculating the load capability thereof for comparison with said load requirements for selecting an alternative profiled, composite pulltruded element from said list fulfilling said load requirements and having said dimensions and forwarding data identifying said alternative profiled, composite pulltruded element along with said negative validation response to said computer,
vi) output of said positive validation response or in the alternative said negative validation response together with said data from said computer,
vii) returning an order to said homepage for the delivery of said specific profiled, composite pulltruded element or in the alternative said alternative profiled, composite pulltruded element, and
viii) delivery of said specific profiled, composite pulltruded element or in the alternative said alternative profiled, composite pulltruded element from a factory.

2. The method according to claim 1 the method further comprising:
said calculation program selecting, provided said comparison in step iv) establishes the non-fulfilment of said load requirements, in step iv) an alternative dimension of said specific profiled, composite pulltruded element and calculating the load capability thereof for comparison with said load requirements for selecting an alternative dimension of said profiled, composite pulltruded element fulfilling said load requirements and forwarding data identifying said alternative dimension of said profiled, composite pulltruded element along with said negative validation response to said computer for output of said validation response from said computer.

3. The method according to any of the preceding claims, said step i) comprising a plurality of sub steps including: definition of static system,
definition of combination of loads on said load-bearing structure,
definition of support of said load-bearing structure including definition of simple or elastic support, fixation or set-up or alternatively Charnier or hinged suspension.

4. The method according to claim 3, said database further including an additional list of fittings to be used in combination with said profile, composite pulltruded elements and said calculation program calculating the load capability of any of said fittings of said additional list in combination said specific profiled, composite pulltruded element determined in step iv) and v).

5. The method according to any of the claims 3 or 4, said database further including a supplementary list of glue connections or bolt connections, and said calculation program calculating the load capability of said glue connection or bolt connection of any of said profiled composite pulltruded elements in combination with such connection and/or in combination with any of said fittings of said additional list.

6. The method according to any of the preceding claims, the method further comprising said database having said list of profiled, composite pulltruded elements organised in clusters of profiled, composite pulltruded elements having the same overall geometrical configuration, said clusters being further organised by ordering said clusters in increasing load capabilities of said profiled, composite pulltruded elements, or in the alternative decreasing load capabilities of said profiled, composite pulltruded elements.

7. The method according to any of the preceding claims, the method further comprising:
said calculation program selecting, provided said comparison in step iv) establishes the non-fulfilment of said load requirements, an alternative specific profiled, composite pulltruded element from the cluster including said specific profiled, composite pulltruded element having a higher load capability.

8. The method according to any of the preceding claims, the method further comprising:
said calculation program selecting, provided said comparison in step iv) establishes the fulfilment of said load requirements, an alternative specific profiled, composite pulltruded element from the cluster including said specific profiled, composite pulltruded element having a lower load capability, said calculation program performing a calculation of an alternative specific load capability of said load-bearing structure comprising said alternative profiled, composite pulltruded element and performing a comparison for comparing said specific alternative load capability with said load requirements of said structure for determining whether or not said load requirements be fulfilled or not, and
said step v) including forwarding said positive validation response regarding said alternative profiled, composite pulltruded element from said calculation program via said homepage provided said comparison in step iv) establishes the fulfilment of said load requirements by said alternative profiled, composite pulltruded element or in the alternative, provided said comparison in step iv) establishes the non-fulfilment of said load requirements by said alternative profiled, composite pulltruded element forwarding no validation response from said calculation program via said homepage regarding said alternative profiled, composite pulltruded element.

9. The method according to any of the preceding claims, said forwarding in step v) further including the forwarding of information regarding said specific load capability determined in step iv) and said step further including output of said information along with said positive validation response or in the alternative said negative validation response.

10. The method according to any of the preceding claims, the method further comprising step vi) further including output of drawings of said load-bearing structure composed of said specific profiled, composite pulltruded element or in the alternative said alternative profiled, composite pulltruded element.

11. The method according to any of the preceding claims, further comprising:
communicating said specific profiled, composite pulltruded element or in the alternative said alternative profiled, composite pulltruded element from said homepage to an inventory program, said inventory program checking delivery times and stock of said specific profiled, composite pulltruded element or in the alternative said alternative profiled, composite pulltruded element and returning information regarding delivery times and stock to said homepage.

12. The method according to any of the preceding claims, further comprising:
communicating said specific profiled, composite pulltruded element or in the alternative said alternative profiled, composite pulltruded element from said homepage to a bookkeeping program, said bookkeeping program checking the price of said specific profiled, composite pulltruded element or in the alternative said alternative profiled, composite pulltruded element and any discount options and returning information regarding said price and any discount options to said homepage.

13. The method according to any of the preceding claims, the method further comprising an introductory measuring step of determining the dimensions of said load-bearing structure and a further introductory step of determining the load requirements thereof.

14. The method according to any of the preceding claims, the method further comprising the final of step of building said load-bearing structure from said specific profiled, composite pulltruded element or in the alternative said alternative profiled, composite pulltruded element.
